# EUROPEAN PATENT APPLICATION

(11) **EP 4 339 568 A1**
(43) Date of publication of application: **20.03.2024**
(21) Application number: 22807314.4
(22) Date of filing: 19.04.2022
(51) Int. Cl.: G01J 1/02, H01L 27/144, H01L 27/146

(54) **INFRARED SENSOR, AND METHOD FOR MANUFACTURING INFRARED SENSOR**

(30) Priority: 11.05.2021 JP 2021080450
(71) Applicant: Panasonic Intellectual Property Management Co., Ltd., Kadoma-shi, Osaka 571-0057 (JP)
(72) Inventor: TAKAHASHI Kouhei, Kadoma-shi, Osaka 571-0057 (JP); FUJIKANE Masaki, Kadoma-shi, Osaka 571-0057 (JP); NAKAMURA Kunihiko, Kadoma-shi, Osaka 571-0057 (JP); HIMENO Atsushi, Kadoma-shi, Osaka 571-0057 (JP); TAMBO Naoki, Kadoma-shi, Osaka 571-0057 (JP); NAKATA Yuki, Kadoma-shi, Osaka 571-0057 (JP); TANAKA Hiroyuki, Kadoma-shi, Osaka 571-0057 (JP)
(74) Representative: Eisenführ Speiser
(86) International application number: PCT/JP2022/018144
(87) International publication number: WO 2022/239611

(57) **Abstract**

An infrared sensor (1a) according to the present disclosure includes a transistor (35), a cavity layer (22), and a sensor layer (15). The cavity layer (22) includes a cavity (25). The sensor layer (15) includes a phononic crystal (11c, 12c) in which holes (10h) are arranged. In plan view, the infrared sensor (1a) includes a first region (5a) and a second region (5b). The first region (5a) includes a transistor (35). The second region (5b) includes the cavity (25). The cavity layer (22) includes a flat major surface (22a). The major surface (22a) is disposed around the cavity (25), and extends across both the first region (5a) and the second region (5b). The sensor layer (15) is disposed on the major surface (22a).

## Description

### Technical Field

The present disclosure relates to an infrared sensor, and a method for manufacturing an infrared sensor.

### Background Art

Devices including an infrared sensor above a cavity are known in the related art.

For example, PTL 1 describes a device including a MEMS component. The device includes a substrate. The substrate includes a transistor region, and a hybrid region. A transistor is disposed in the transistor region. A lower sensor cavity is disposed in the hybrid region. The MEMS component is disposed above the lower sensor cavity in the hybrid region. The MEMS component includes a thermoelectric infrared sensor.

Infrared sensors including a thin film with a phononic crystal are also known.

For example, PTL 2 describes a thermopile infrared sensor including a beam. The beam is a substance in the form of a thin film having a two-dimensional phononic crystal. In the two-dimensional phononic crystal, through-holes of a given diameter are arranged in-plane with a given period. According to PTL 2, microfabrication is performed such that, within the beam, the period of the through-holes increases at given intervals in the direction from an infrared receiver toward a base substrate. Enhanced thermal insulation is thus provided across the entire beam. This results in enhanced sensitivity of the infrared sensor.

Further, PTL 3 and NPL 1 each disclose a periodic structure of through-holes for reducing the thermal conductivity of a thin film. In the periodic structure, in plan view of the thin film, the through-holes are arranged regularly with a nanometer-order period ranging from 1 nanometer (nm) to 1000 nm. The periodic structure is a type of phononic crystal structure.

### Citation List

### Patent Literature

PTL 1: U.S. Patent No. 10,199,424
PTL 2: Japanese Unexamined Patent Application Publication No. 2017-223644
PTL 3: U.S. Patent Application Publication No. 2015/0015930

### Non Patent Literature

NPL 1: Nomura et al., "Impeded thermal transport in Si multiscale hierarchical architectures with phononic crystal nanostructures", Physical Review B 91, 205422 (2015)

### Summary of Invention

The techniques mentioned above have room for reexamination from the viewpoint of improving the detection sensitivity of an infrared sensor including a transistor and a cavity.

Accordingly, the present disclosure provides a technique that is advantageous from the viewpoint of increasing the sensitivity of infrared detection for an infrared sensor including a transistor and a cavity.

The present disclosure provides an infrared sensor described below.

An infrared sensor including:
a transistor;
a cavity layer including a cavity; and
a sensor layer including a phononic crystal in which holes are arranged,
in which in plan view, the infrared sensor includes a first region and a second region, the first region including the transistor, the second region including the cavity,
in which the cavity layer includes a flat major surface, the flat major surface being disposed around the cavity and extending across both the first region and the second region, and
in which the sensor layer is disposed on the flat major surface.

The infrared sensor according to the present disclosure is advantageous from the viewpoint that the infrared sensor provides increased infrared detection sensitivity while including the transistor and the cavity.

### Brief Description of Drawings

[Fig. 1A] Fig. 1A is a cross-sectional view of an infrared sensor according to Embodiment 1.
[Fig. 1B] Fig. 1B is a schematic plan view of the infrared sensor according to Embodiment 1.
[Fig. 2A] Fig. 2A is a plan view of an example of the unit cell of a phononic crystal.
[Fig. 2B] Fig. 2B is a plan view of another example of the unit cell of a phononic crystal.
[Fig. 2C] Fig. 2C is a plan view of still another example of the unit cell of a phononic crystal.
[Fig. 2D] Fig. 2D is a plan view of still another example of the unit cell of a phononic crystal.
[Fig. 2E] Fig. 2E is a plan view of an example of a phononic crystal.
[Fig. 2F] Fig. 2F is a plan view of another example of a phononic crystal.
[Fig. 2G] Fig. 2G is a plan view of still another example of a phononic crystal.
[Fig. 2H] Fig. 2H is a plan view of still another example of a phononic crystal.
[Fig. 2I] Fig. 2I is a plan view of still another example of a phononic crystal.
[Fig. 2J] Fig. 2J is a plan view of still another example of a phononic crystal.
[Fig. 2K] Fig. 2K is a plan view of still another example of a phononic crystal.
[Fig. 2L] Fig. 2L is a plan view of still another example of a phononic crystal.
[Fig. 2M] Fig. 2M is a plan view of still another example of a phononic crystal.
[Fig. 2N] Fig. 2N is a plan view of still another example of a phononic crystal.
[Fig. 2O] Fig. 2O is a plan view of still another example of a phononic crystal.
[Fig. 3A] Fig. 3A is a cross-sectional view of a modification of the infrared sensor according to Embodiment 1.
[Fig. 3B] Fig. 3B is a cross-sectional view of another modification of the infrared sensor according to Embodiment 1.
[Fig. 3C] Fig. 3C is a cross-sectional view of still another modification of the infrared sensor according to Embodiment 1.
[Fig. 3D] Fig. 3D is a cross-sectional view of still another modification of the infrared sensor according to Embodiment 1.
[Fig. 3E] Fig. 3E is a cross-sectional view of still another modification of the infrared sensor according to Embodiment 1.
[Fig. 3F] Fig. 3F is a cross-sectional view of still another modification of the infrared sensor according to Embodiment 1.
[Fig. 3G] Fig. 3G is a cross-sectional view of still another modification of the infrared sensor according to Embodiment 1.
[Fig. 4A] Fig. 4A is a cross-sectional view of the infrared sensor according to Embodiment 1, illustrating a method for manufacturing the infrared sensor.
[Fig. 4B] Fig. 4B is a cross-sectional view of the infrared sensor according to Embodiment 1, illustrating the method for manufacturing the infrared sensor.
[Fig. 4C] Fig. 4C is a cross-sectional view of the infrared sensor according to Embodiment 1, illustrating the method for manufacturing the infrared sensor.
[Fig. 4D] Fig. 4D is a cross-sectional view of the infrared sensor according to Embodiment 1, illustrating the method for manufacturing the infrared sensor.
[Fig. 4E] Fig. 4E is a cross-sectional view of the infrared sensor according to Embodiment 1, illustrating the method for manufacturing the infrared sensor.
[Fig. 4F] Fig. 4F is a cross-sectional view of the infrared sensor according to Embodiment 1, illustrating the method for manufacturing the infrared sensor.
[Fig. 4G] Fig. 4G is a cross-sectional view of the infrared sensor according to Embodiment 1, illustrating the method for manufacturing the infrared sensor.
[Fig. 4H] Fig. 4H is a cross-sectional view of the infrared sensor according to Embodiment 1, illustrating the method for manufacturing the infrared sensor.
[Fig. 4I] Fig. 4I is a cross-sectional view of the infrared sensor according to Embodiment 1, illustrating the method for manufacturing the infrared sensor.
[Fig. 4J] Fig. 4J is a cross-sectional view of the infrared sensor according to Embodiment 1, illustrating the method for manufacturing the infrared sensor.
[Fig. 4K] Fig. 4K is a cross-sectional view of the infrared sensor according to Embodiment 1, illustrating the method for manufacturing the infrared sensor.
[Fig. 5A] Fig. 5A is a schematic plan view of a sensor array according to Embodiment 2.
[Fig. 5B] Fig. 5B is a schematic plan view of a sensor array according to Embodiment 2.

### Description of Embodiments

### (Underlying Knowledge Forming Basis of the Present Disclosure)

It is considered that for an infrared sensor, separation between the infrared receiver and the substrate due to the cavity tends to result in increased thermal insulation between the infrared receiver and the substrate, and consequently increased infrared detection accuracy. In this case, a component such as a beam is required to support the infrared receiver. It is considered that if such a component has high thermal insulation, infrared detection accuracy tends to increase.

One conceivable way to reduce the thermal conductivity of such a component is to make the component porous. A component including a phononic crystal may exhibit a thermal insulation performance exceeding the thermal insulation performance that can be traditionally achieved through reduction of thermal conductance resulting from decreased volume of the component associated with the porous structure of the component. For example, PTL 2 describes that introducing a phononic crystal to the beam supporting the infrared receiver may improve the sensitivity of the infrared sensor. To form such a phononic crystal, it is conceivable to employ lithography processes including photolithography, electron beam lithography, and block copolymer (BCP) lithography. A phononic crystal includes an arrangement of holes with a period or diameter of 10 nm to 1000 nm. Formation of a phononic crystal thus requires very high exposure accuracy and uniform formation of the coating of a resist film or other film.

It is conceivable to form an infrared sensor such that in plan view, the infrared sensor has a region including a transistor, and a region including a cavity, as with the infrared sensor described in PTL 1. In this case, irregularities that result in steps with a height of about 1 µm may occur between the region including the transistor and the region including the cavity. An investigation by the present inventors has found that lithography performed on such an irregular surface to form a phononic crystal can cause many defects in the phononic crystal, which may make it impossible to sufficiently increase thermal insulation. For example, the steps resulting from the irregularities cause defocusing during exposure, leading to decreased exposure accuracy. Another potential defect is insufficient coverage of the coating of the resist film or other film at the edges of the steps resulting from the irregularities, or formation of pinholes in the depressions of the irregularities. In addition, the coating of the resist film or other film tends to become uneven. Due to the circumstances mentioned above, many defects develop in the phononic crystal, which results in the inability to sufficiently increase thermal insulation. This makes it difficult to increase the detection accuracy of the infrared sensor.

Accordingly, the present inventors have made intensive studies with regard to a technique for increasing the infrared detection accuracy of an infrared sensor including a transistor and a cavity. As a result, the inventors have obtained the knowledge that infrared detection accuracy can be increased by adjusting the configuration of a major surface of a layer including the cavity. Based on this novel knowledge, the inventors have completed the present disclosure.

### (Overview of One Aspect of Present Disclosure)

The present disclosure provides an infrared sensor described below.

An infrared sensor including:
a transistor;
a cavity layer including a cavity; and
a sensor layer including a phononic crystal in which holes are arranged,
in which in plan view, the infrared sensor includes a first region and a second region, the first region including the transistor, the second region including the cavity,
in which the cavity layer includes a flat major surface, the flat major surface being disposed around the cavity and extending across both the first region and the second region, and
in which the sensor layer is disposed on the flat major surface.

With the infrared sensor described above, the sensor layer is disposed on the flat major surface of the cavity layer. The flat major surface is disposed around the cavity, and extends across both the first region and the second region. This configuration tends to result in reduced defects in the phononic crystals. The infrared sensor described above is therefore advantageous from the viewpoint that the infrared sensor provides increased infrared detection sensitivity while including the transistor and the cavity. The flat major surface of the cavity layer may be such that the mean height from the surface of the substrate to the major surface of the cavity layer in the first region, and the mean height from the surface of the substrate to the major surface of the cavity layer in the second region have a difference of less than or equal to 50 nm.

### (Embodiments of Present Disclosure)

Embodiments of the present disclosure will be described below with reference to the drawings. Embodiments described below each represent a generic or specific example. Specific details set forth in the following description of embodiments, such as numeric values, shapes, materials, components, the positioning of components, the connections of components, process conditions, steps, and the order of steps, are for illustrative purposes only and not intended to limit the scope of the present disclosure. Those components in the following description of embodiments which are not cited in the independent claim representing the most generic concept of the present disclosure will be described as optional components. It is to be understood that the drawings are schematic in nature, and not necessarily drawn to scale.

### (Embodiment 1)

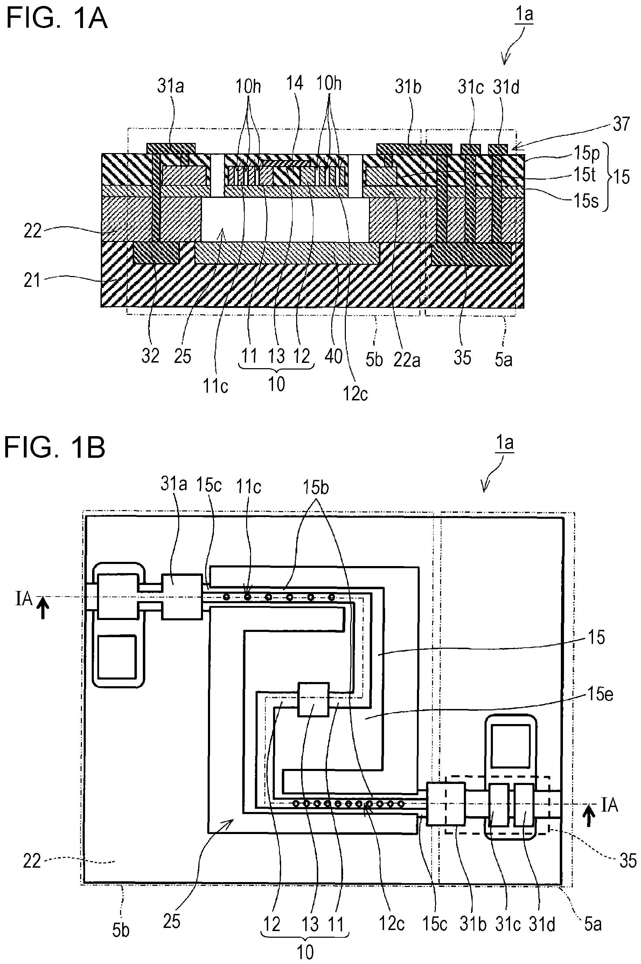

Figs. 1A and 1B illustrate an infrared sensor 1a according to Embodiment 1. Fig. 1A is a cross-sectional view of the infrared sensor 1a taken along a line IA-IA in Fig. 1B. The infrared sensor 1a includes a transistor 35, a cavity layer 22, and a sensor layer 15. The transistor 35 is, for example, a metal-oxide-semiconductor (MOS) field-effect transistor. The transistor 35 serve as, for example, a pixel selection switch for a sensor array. The cavity layer 22 includes a cavity 25. The sensor layer 15 includes phononic crystals 11c and 12c in which holes 10h are arranged. In plan view, the infrared sensor 1a includes a first region 5a, and a second region 5b. The first region 5a includes the transistor 35. The second region 5b includes the cavity 25. The cavity layer 22 includes a flat major surface 22a. The major surface 22a is disposed around the cavity 25, and extends across both the first region 5a and the second region 5b. The sensor layer 15 is disposed on the major surface 22a.

As illustrated in Figs. 1A and 1B, for example, in plan view of the infrared sensor 1a, the second region 5b is adjacent to the first region 5a. The second region 5b includes, for example, an element used for infrared sensing. The transistor 35 in the first region 5a exhibits, for example, a switching action with respect to the element used for infrared sensing included in the second region 5b adjacent to the first region 5a.

As illustrated in Fig. 1A, the infrared sensor 1a includes, for example, a substrate 21, and a wiring layer 37. The cavity layer 22 is disposed on the substrate 21. The cavity layer 22 is disposed between the substrate 21 and the sensor layer 15 in the direction of its thickness. The cavity layer 22 is formed as an interlayer film.

The infrared sensor 1a includes, for example, an infrared reflector 40. The infrared reflector 40 reflects infrared radiation toward the sensor layer 15. This configuration tends to result in increased infrared detection accuracy of the infrared sensor 1a.

The infrared reflector 40 is, for example, in the form of a layer. For example, the infrared reflector 40 defines at least part of one major surface of the substrate 21, and is in contact with the cavity 25. For example, the infrared reflector 40 defines the same plane as that of the major surface of the substrate 21 around the infrared reflector 40.

The material of the infrared reflector 40 is not limited to a particular material. The material of the infrared reflector 40 includes, for example, doped silicon with a carrier density greater than or equal to 1.0 × 10¹⁹ cm⁻³. In this case, high temperature annealing can be used in the manufacture of the infrared sensor 1a. For example, if the substrate 21 is a Si substrate, the infrared reflector 40 can be formed by implantation of a dopant into the surface of the substrate 21. The infrared reflector 40 may include a material with a melting point higher than or equal to 850°C. As a result, high temperature annealing can be used in the manufacture of the infrared sensor 1a. The infrared reflector 40 may be made of a metal such as tungsten, or may be made of a metal compound such as TiN or TaN.

As illustrated in Fig. 1A, the sensor layer 15 includes, for example, a support layer 15s, a thermocouple 10, and a protective layer 15p. The thermocouple 10 is disposed on the support layer 15s. The thermocouple 10 includes the phononic crystals 11c and 12c. The protective layer 15p covers the phononic crystals 11c and 12c.

The thermocouple 10 includes, for example, a p-type part 11, and an n-type part 12. The p-type part 11 includes a p-type material, and has, for example, a positive Seebeck coefficient. The n-type part 12 includes an n-type material, and has, for example, a negative Seebeck coefficient. The p-type part 11 includes a first phononic crystal 11c in which the holes 10h are arranged in plan view. The n-type part 12 includes a second phononic crystal 12c in which the holes 10h are arranged in plan view.

The sensor layer 15 includes, for example, a thermocouple layer 15t. The thermocouple layer 15t includes the p-type part 11 and the n-type part 12. The thermocouple 10 includes, for example, a hot junction 13. The hot junction 13 is, for example, disposed on the thermocouple layer 15t. The hot junction 13 electrically connects the p-type part 11 and the n-type part 12 to each other. Accordingly, the p-type part 11, the n-type part 12, and the hot junction 13 constitute a thermocouple element. The thermocouple layer 15t includes, for example, a non-doped part 14 doped with no impurity. The thermocouple layer 15t may be made up of the p-type part 11 and the n-type part 12.

The thickness of each of the support layer 15s, the thermocouple layer 15t, and the protective layer 15p is not limited to a particular value. For example, the support layer 15s, the thermocouple layer 15t, and the protective layer 15p each have a thickness from 10 nm to 1000 nm. Each of the support layer 15s and the protective layer 15p may be of a single-layer structure, or may be of a multi-layer structure.

As illustrated in Fig. 1A, the infrared sensor 1a includes the wiring layer 37. The wiring layer 37 is disposed on top of the sensor layer 15. The wiring layer 37 includes a wiring line 31a, a wiring line 31b, a wiring line 31c, and a wiring line 31d.

The wiring line 31a extends within a contact hole defined in the sensor layer 15 and in the cavity layer 22. The wiring line 31a electrically connects one end of the thermocouple 10 and a ground 32 to each other. The wiring line 31b extends within a contact hole defined in the sensor layer 15 and in the cavity layer 22. The wiring line 31b electrically connects the other end of the thermocouple 10 and the transistor 35 to each other. The wiring line 31c and the wiring line 31d each extend within a different contact hole. The transistor 35, and a signal processing circuit disposed on a different substrate or on the same substrate are thus electrically connected to each other.

As illustrated in Fig. 1B, the sensor layer 15 includes a beam 15b, a joint 15c, and an infrared receiver 15e. In Fig. 1B, the protective layer 15p is not illustrated for convenience of illustration. The joint 15c connects the sensor layer 15 to the cavity layer 22. For example, the joint 15c is in contact with the cavity layer 22. The beam 15b is connected to the infrared receiver 15e. The beam 15b supports the infrared receiver 15e at a location away from the cavity layer 22. The beam 15b and the infrared receiver 15e include the thermocouple layer 15t. In plan view of the infrared sensor 1a, the beam 15b and the infrared receiver 15e overlap the cavity 25. The first phononic crystal 11c and the second phononic crystal 12c are formed in, for example, the beam 15b. This tends to result in the beam 15b having high thermal insulation, which tends to lead to increased infrared detection accuracy of the infrared sensor 1a. Alternatively, the first phononic crystal 11c and the second phononic crystal 12c may be formed in the infrared receiver 15e. The hot junction 13 is disposed in the infrared receiver 15e.

As illustrated in Fig. 1A, the first phononic crystal 11c and the second phononic crystal 12c are formed in the thermocouple layer 15t. Alternatively, in the sensor layer 15, the phononic crystals may be formed in the support layer 15s, or may be formed in the protective layer 15p. The holes 10h in the phononic crystals may be through-holes extending through the sensor layer 15, or may be blind holes. Forming the holes 10h as through-holes tends to result in increased thermal insulation of the beam 15b. Forming the holes 10h as blind holes tends to result in increased mechanical strength of the sensor layer 15.

Incidence of infrared radiation on the infrared receiver 15e causes the temperature of the infrared receiver 15e to rise. At this time, the higher the thermal insulation between the infrared receiver 15e and the substrate 21, which serves as a heat bath, the greater the temperature rise of the infrared receiver 15e. As the temperature of the infrared receiver 15e rises, an electromotive force is generated in the thermocouple 10 due to the Seebeck effect. As the generated electromotive force is processed in the signal processing circuit, the infrared sensor 1a senses infrared radiation. Depending on the signal processing performed in the signal processing circuit, the infrared sensor 1a is capable of measuring the intensity of infrared radiation and/or measuring the temperature of an object of interest.

As illustrated in Fig. 1B, the sensor layer 15 includes the infrared receiver 15e, which is in contact with the cavity 25. The presence of the cavity 25 in the infrared sensor 1a allows high thermal insulation between the infrared receiver 15e of the sensor layer 15, and the heat bath. Moreover, around the cavity 25, the flat major surface 22a extends across both the first region 5a and the second region 5b, and no irregularities are present. This results in relatively few defects in the first phononic crystal 11c and the second phononic crystal 12c, which in turn tends to result in increased thermal insulation between the infrared receiver of the sensor layer 15, and the substrate 21 serving as the heat bath. Therefore, the infrared detection accuracy of the infrared sensor 1a tends to increase.

The shape of the holes 10h in each of the first phononic crystal 11c and the second phononic crystal 12c is not limited to a particular shape. In plan view of the first phononic crystal 11c or the second phononic crystal 12c, the holes 10h may have a circular shape, or may have a polygonal shape such as a triangular shape or a quadrangular shape.

For example, in each of the first phononic crystal 11c and the second phononic crystal 12c, the arrangement of the holes 10h has periodicity. In other words, in plan view of the first phononic crystal 11c or the second phononic crystal 12c, the holes 10h are arranged regularly. The holes 10h have a period of, for example, 1 nm to 5 µm. Since the wavelength of heat-carrying phonons ranges mainly from 1 nm up to 5 µm, the fact that the holes 10h have a period ranging from 1 nm to 5 µm is advantageous from the viewpoint of reducing the thermal conductivity of each of the first phononic crystal 11c and the second phononic crystal 12c.

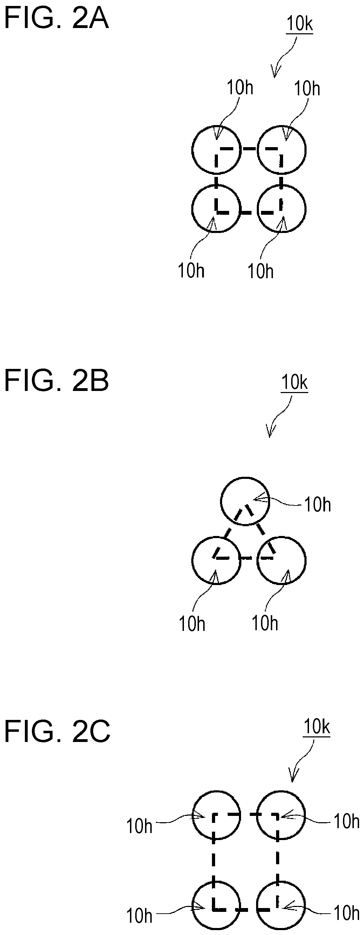

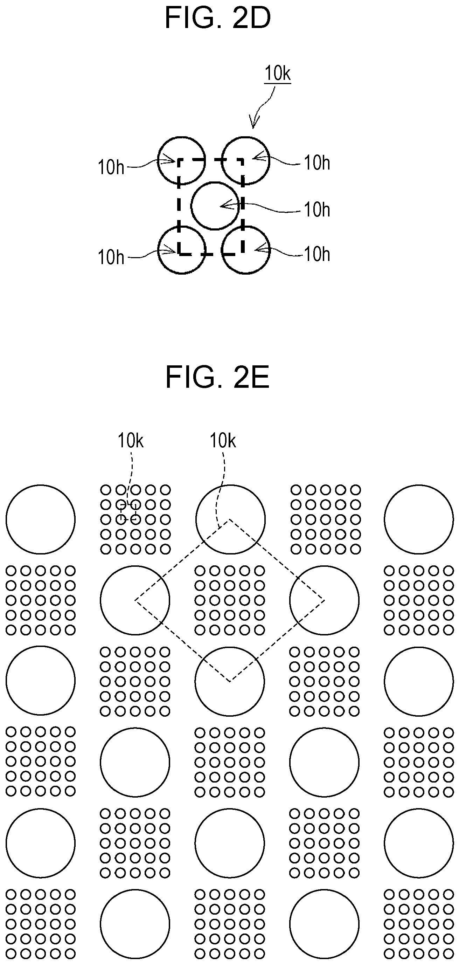

Figs. 2A, 2B, 2C, and 2D each illustrate an example of a unit cell 10k of a phononic crystal. The unit cell of each of the first phononic crystal 11c and the second phononic crystal 12c is not limited to a particular unit cell. As illustrated in Fig. 2A, the unit cell 10k may be a square lattice. As illustrated in Fig. 2B, the unit cell 10k may be a triangular lattice. As illustrated in Fig. 2C, the unit cell 10k may be a rectangular lattice. As illustrated in Fig. 2D, the unit cell 10k may be a face-centered rectangular lattice.

The first phononic crystal 11c and the second phononic crystal 12c may each include different kinds of unit cells. Fig. 2E illustrate an example of a phononic crystal. As illustrated in Fig. 2E, the first phononic crystal 11c or the second phononic crystal 12c may include, for example, different arrangement patterns of holes 10h with two different kinds of unit cells 10k.

The manner in which the holes 10h are arranged in the first phononic crystal 11c, and the manner in which the holes 10h are arranged in the second phononic crystal 12c may be the same or may be different. Due to the above-mentioned structure of each phononic crystal in which holes are arranged, the interface scattering frequency of phonons can be adjusted, and thus the effective mean free path of phonons can be adjusted. The shorter the characteristic length of a structure or other object, the higher the interface scattering frequency of phonons.

In the infrared sensor 1a, the interface scattering frequency of phonons in the first phononic crystal 11c differs from the interface scattering frequency of phonons in the second phononic crystal 12c. Alternatively, the interface scattering frequency of phonons in the first phononic crystal 11c may be the same as the interface scattering frequency of phonons in the second phononic crystal 12c.

A case is now considered where the thermal conductivity of the p-type material included in the p-type part 11, and the thermal conductivity of the n-type material included in the n-type part 12 are different from each other. In this case, if the interface scattering frequency of phonons in the first phononic crystal 11c differs from the interface scattering frequency of phonons in the second phononic crystal 12c, the thermal stress generated in the thermocouple 10 tends to decrease. This is because the difference between the thermal conductivity in the p-type part 11 and the thermal conductivity in the n-type part 12 can be reduced, which tends to result in uniform temperature distribution in the thermocouple 10. This tends to result in reduced risk of breakdown of the thermocouple 10 or other components of the infrared sensor 1a. As used herein, the term thermal conductivity means, for example, a value at 25°C.

The infrared sensor 1a satisfies, for example, at least one condition selected from the group consisting of (i), (ii), and (iii) described below. This may allow the first phononic crystal 11c and the second phononic crystal 12c to differ in the interface scattering frequency of phonons. Or,
(i) The shortest distance between the two mutually closest holes 10h in plan view of the first phononic crystal 11c differs from the shortest distance between two mutually closest holes 10h in plan view of the second phononic crystal 12c.
(ii) A ratio R1 differs from a ratio R2. The ratio R1 is the ratio of the sum of the areas of the holes 10h to the area of the first phononic crystal 11c in plan view of the first phononic crystal 11c. The ratio R2 is the ratio of the sum of the areas of the holes 10h to the area of the second phononic crystal 12c in plan view of the second phononic crystal 12c.
(iii) A specific surface area SV1 differs from a specific surface area SV2. The specific surface area SV1 is determined by dividing the surface area of the first phononic crystal 11c by the volume of the first phononic crystal 11c. The specific surface area SV2 is determined by dividing the surface area of the second phononic crystal 12c by the volume of the second phononic crystal 12c.

It is assumed that in the first phononic crystal 11c or the second phononic crystal 12c, the shortest distance between two mutually closest holes 10h differs depending on the location within the corresponding phononic crystal. In this case, for example, for each individual hole 10h, the shortest distance to the closest hole 10h is determined. Then, the sum total of the shortest distances determined for such multiple holes 10h may be divided by the number of the holes 10h to thereby determine the shortest distance between two mutually closest holes 10h in plan view of the first phononic crystal 11c or the second phononic crystal 12c.

If the thermal conductivity of the p-type material in the p-type part 11 is higher than the thermal conductivity of the n-type material in the n-type part 12, then, for example, the interface scattering frequency of phonons in the first phononic crystal 11c is higher than the interface scattering frequency of phonons in the second phononic crystal 12c. In this case, for example, at least one condition selected from the group consisting of (ia), (iia), and (iiia) described below is satisfied.
(ia) The shortest distance between two mutually closest holes 10h in plan view of the first phononic crystal 11c is less than the shortest distance between two mutually closest holes 10h in plan view of the second phononic crystal 12c.
(iia) The ratio R1 is greater than the ratio R2.
(iiia) The specific surface area SV1 is greater than the specific surface area SV2.

If the thermal conductivity of the n-type material in the n-type part 12 is higher than the thermal conductivity of the p-type material in the p-type part 11, then, for example, the interface scattering frequency of phonons in the second phononic crystal 12c is higher than the interface scattering frequency of phonons in the first phononic crystal 11c. In this case, for example, at least one condition selected from the group consisting of (ib), (iib), and (iiib) described below is satisfied.
(ib) The shortest distance between two mutually closest holes 10h in plan view of the second phononic crystal 12c is less than the shortest distance between two mutually closest holes 10h in plan view of the first phononic crystal 11c.
(iib) The ratio R2 is greater than the ratio R1.
(iiib) The specific surface area SV2 is greater than the specific surface area SV1.

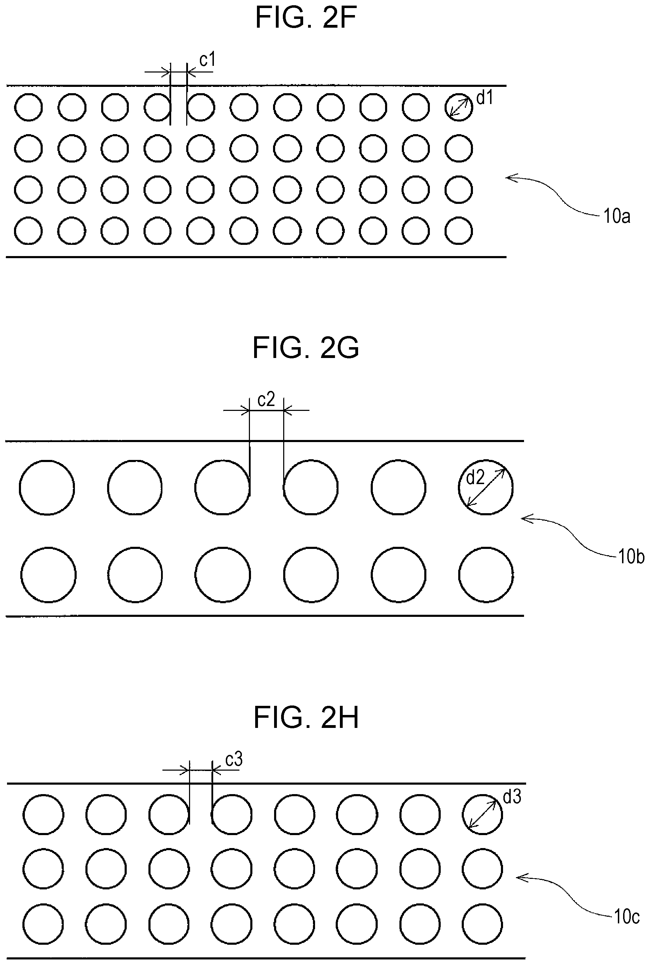

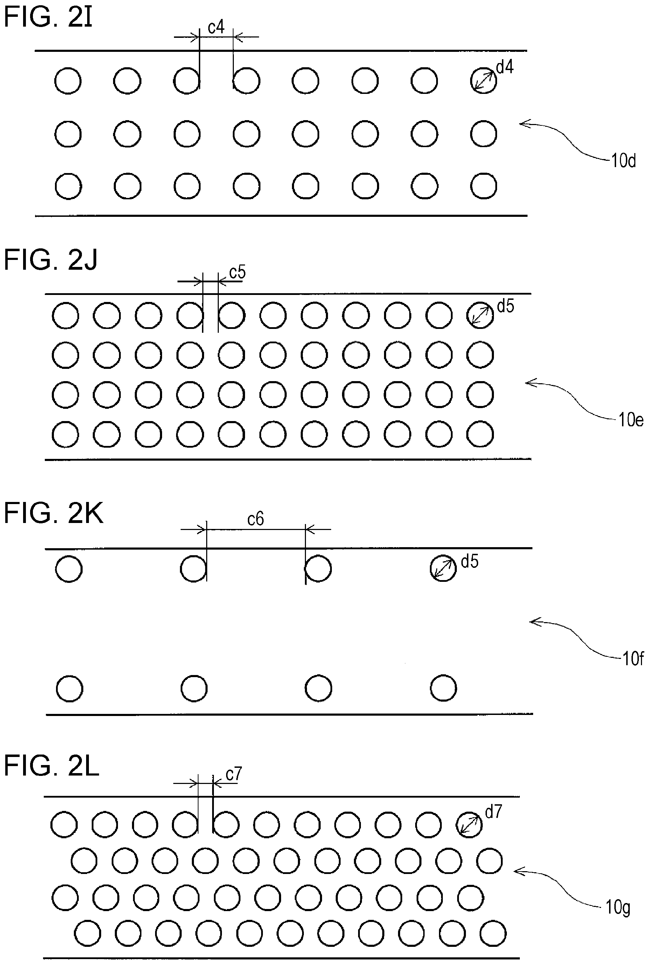

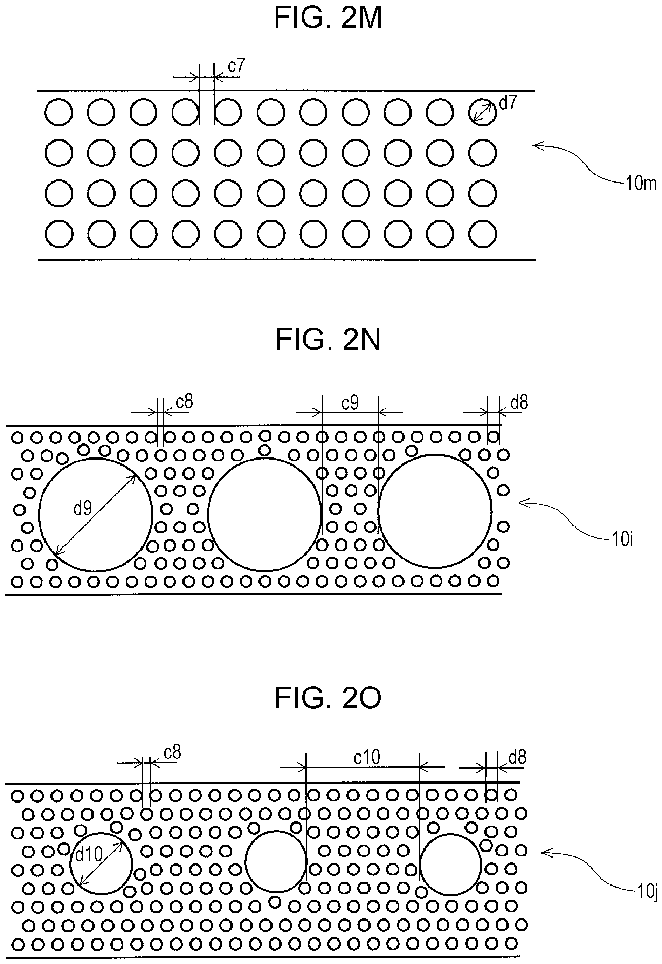

Figs. 2F, 2G, 2H, 2I, 2J, 2K, 2L, 2M, 2N, and 2O each illustrate an example of a phononic crystal constituting each of the first phononic crystal 11c and the second phononic crystal 12c.

One of the first phononic crystal 11c and the second phononic crystal 12c may be, for example, a phononic crystal 10a illustrated in Fig. 2F. In addition, the other of the first phononic crystal 11c and the second phononic crystal 12c may be, for example, a phononic crystal 10b illustrated in Fig. 2G.

In plan view of the phononic crystal 10a, the diameter of each hole 10h is d1, and the shortest distance between two mutually closest holes 10h is c1. In plan view of the phononic crystal 10b, the diameter of each hole 10h is d2, and the shortest distance between two mutually closest holes 10h is c2. Although the relationship that d1 > d2 is satisfied, for each of the phononic crystal 10a and the phononic crystal 10b, the value obtained by dividing the diameter of each hole 10h by the period of the arrangement of the holes 10h is the same. Accordingly, for each of the phononic crystal 10a and the phononic crystal 10b, the ratio of the sum of the areas of the holes to the area of the phononic crystal in plan view is the same. Meanwhile, the relationship that c1 < c2 is satisfied, and thus the interface scattering frequency of phonons in the phononic crystal 10a is higher than the interface scattering frequency of phonons in the phononic crystal 10b.

The shortest distance between two mutually closest holes in a phononic crystal can be adjusted by, for example, the period of the regular arrangement of the holes. As an example, a case is considered where the base material of the phononic crystal is Si, the ratio of the sum of the areas of the holes to the area of the phononic crystal in plan view is 50%, and the holes are arranged regularly with a period of less than or equal to 100 nm. In this case, changing the period of the arrangement of the holes by 10% may cause the thermal conductivity of the phononic crystal to change by greater than or equal to 15%. As another example, a case is considered where the base material of the phononic crystal is Si, the ratio of the sum of the areas of the holes to the area of the phononic crystal in plan view is 50%, and the holes are arranged regularly with a period of less than or equal to 50 nm. In this case, changing the period of the arrangement of the holes by 5% may cause the thermal conductivity of the phononic crystal to change by greater than or equal to 10%. Accordingly, for example, it would be conceivable to adjust the difference between the period of the arrangement of the holes in the phononic crystal included in the p-type part, and the period of the arrangement of the holes in the phononic crystal included in the n-type part to about 5%. This makes it possible to sufficiently reduce the difference between the thermal conductivity of the phononic crystal in the p-type part and the thermal conductivity of the phononic crystal in the n-type part, and consequently reduce the risk of breakdown of the thermocouple or other components of the infrared sensor. It is to be noted that the greater the ratio of the sum of the areas of holes to the area of a phononic crystal in plan view, the greater the change in the thermal conductivity of the phononic crystal that may be caused by a slight change in the period of the arrangement of the holes.

One of the first phononic crystal 11c and the second phononic crystal 12c may be a phononic crystal 10c illustrated in Fig. 2H. In addition, the other of the first phononic crystal 11c and the second phononic crystal 12c may be a phononic crystal 10d illustrated in Fig. 2I.

In plan view of the phononic crystal 10c, the diameter of each hole 10h is d3, and the shortest distance between two mutually closest holes 10h is c3. In plan view of the phononic crystal 10d, the diameter of each hole 10h is d4, and the shortest distance between two mutually closest holes 10h is c4. The period of the arrangement of the holes 10h is the same between the phononic crystal 10c and the phononic crystal 10d. For the phononic crystal 10c and the phononic crystal 10d, the following relationship is satisfied: d3 > d4 and c3 < c4. Now, the following items are considered: the shortest distance between two mutually closest holes 10h; the ratio of the sum of the areas of the holes 10h to the area of a phononic crystal in plan view; and the value obtained by dividing the sum of the perimeters of the holes 10h in plan view of a phononic crystal by the area of the first phononic crystal. By taking these items into consideration, the interface scattering frequency of phonons in the phononic crystal 10c is higher than the interface scattering frequency of phonons in the phononic crystal 10d.

For example, a case is considered where the base material of the phononic crystal is Si, the holes are arranged regularly with a period of 300 nm, and the ratio of the sum of the areas of the holes to the area of a phononic crystal in plan view is greater than 19%. In this case, changing the ratio of the sum of the areas of the holes to the area of the phononic crystal in plan view by 2% may cause the thermal conductivity of the phononic crystal to change by greater than or equal to 10%. Accordingly, for example, it would be conceivable to adjust the difference between the ratio of the sum of the areas of the holes to the area of the phononic crystal in the p-type part in plan view, and the ratio of the sum of the areas of the holes to the area of the phononic crystal in the p-type part in plan view to about 2%. This makes it possible to sufficiently reduce the difference between the thermal conductivity in the p-type part and the thermal conductivity in the n-type part, and consequently reduce the risk of breakdown of the thermocouple or other components of the infrared sensor. It is to be noted that the less the period of the arrangement of the holes in a phononic crystal, the greater the change in the thermal conductivity of the phononic crystal that may be caused by a slight change in the ratio of the sum of the areas of the holes to the area of the phononic crystal in plan view.

One of the first phononic crystal 11c and the second phononic crystal 12c may be a phononic crystal 10e illustrated in Fig. 2J. In addition, the other of the first phononic crystal 11c and the second phononic crystal 12c may be a phononic crystal 10f illustrated in Fig. 2K.

In plan view of the phononic crystal 10e, the diameter of each hole 10h is d5, and the shortest distance between two mutually closest holes 10h is c5. In plan view of the phononic crystal 10f, the diameter of each hole 10h is d5, and the shortest distance between two mutually closest holes 10h is c6. In plan view of the phononic crystal 10e and the phononic crystal 10f, the diameter of each hole 10h is the same between these phononic crystals. Meanwhile, the condition that c5 < c6 is satisfied. Now, the following items are considered: the shortest distance between two mutually closest holes 10h; the ratio of the sum of the areas of the holes 10h to the area of a phononic crystal in plan view; and the value obtained by dividing the sum of the perimeters of the holes 10h in plan view of a phononic crystal by the area of the first phononic crystal. With these items taken into consideration, the interface scattering frequency of phonons in the phononic crystal 10e is higher than the interface scattering frequency of phonons in the phononic crystal 10f.

One of the first phononic crystal 11c and the second phononic crystal 12c may be a phononic crystal 10g illustrated in Fig. 2L. In addition, the other of the first phononic crystal 11c and the second phononic crystal 12c may be a phononic crystal 10m illustrated in Fig. 2M.

In plan view of the phononic crystal 10g and the phononic crystal 10m, the diameter of each hole 10h is d7, and the shortest distance between two mutually closest holes 10h is c7. In plan view of the phononic crystal 10g, the unit cell of the arrangement of the holes 10h is a triangular lattice. In plan view of the phononic crystal 10m, the unit cell of the arrangement of the holes 10h is a square lattice. A triangular lattice has a packing fraction higher than the packing fraction of a square lattice. Now, the following items are considered: the ratio of the sum of the areas of the holes 10h to the area of a phononic crystal in plan view; and the value obtained by dividing the sum of the perimeters of the holes 10h in plan view of a phononic crystal by the area of the first phononic crystal. With these items taken into consideration, the interface scattering frequency of phonons in the phononic crystal 10g is higher than the interface scattering frequency of phonons in the phononic crystal 10m.

One of the first phononic crystal 11c and the second phononic crystal 12c may be a phononic crystal 10i illustrated in Fig. 2N. In addition, the other of the first phononic crystal 11c and the second phononic crystal 12c may be a phononic crystal 10j illustrated in Fig. 2O.

Each of the phononic crystal 10i and the phononic crystal 10j has, with respect to the arrangement of the holes 10h, multiple kinds of arrangement patterns. The phononic crystal 10i has, in plan view, an arrangement pattern of holes 10h in which the diameter of each hole 10h is d8, and in which the shortest distance between two mutually closest holes 10h is c8. In addition, the phononic crystal 10i has, in plan view, an arrangement pattern of holes 10h in which the diameter of each hole 10h is d9, and in which the shortest distance between two mutually closest holes 10h is c9. The phononic crystal 10j has, in plan view, an arrangement pattern of holes 10h in which the diameter of each hole 10h is d8, and in which the shortest distance between two mutually closest holes 10h is c8. In addition, the phononic crystal 10i has, in plan view, an arrangement pattern of holes 10h in which the diameter of each hole 10h is d10, and in which the shortest distance between two mutually closest holes 10h is c10. The relationship that d9 > d10 is satisfied. With the ratio of the sum of the areas of the holes 10h to the area of a phononic crystal in plan view being taken into consideration, the interface scattering frequency of phonons in the phononic crystal 10i is higher than the interface scattering frequency of phonons in the phononic crystal 10j.

The difference between the thermal conductivity of the first phononic crystal 11c and the thermal conductivity of the second phononic crystal 12c is not limited to a particular value. The difference is, for example, less than or equal to 10% of the lower one of the thermal conductivity of the first phononic crystal 11c and the thermal conductivity of the second phononic crystal 12c. This tends to allow the thermocouple 10 to maintain uniform temperature, which makes it possible to reduce the risk of breakdown of a component of the infrared sensor 1a caused by thermal stress. Alternatively, the difference between the thermal conductivity of the first phononic crystal 11c and the thermal conductivity of the second phononic crystal 12c may be greater than or equal to 10% of the lower one of these thermal conductivities. It is to be understood that it is effective to make the difference in thermal conductivity between the first phononic crystal 11c and the second phononic crystal 12c less than the difference in thermal conductivity between the p-type material included in the p-type part 11 and the n-type material included in the n-type part 12.

The difference between the thermal conductivity of the first phononic crystal 11c and the thermal conductivity of the second phononic crystal 12c is, for example, less than or equal to 5 W/(m·K). The difference may be less than or equal to 1 W/(m·K), or may be less than or equal to 0.5 W/(m·K).

The substrate 21 is typically made of a semiconductor. The semiconductor is, for example, Si. It is to be noted, however, that the substrate 21 may be made of a semiconductor other than Si, or a material other than a semiconductor.

The material of the cavity layer 22 is not limited to a particular material. The cavity layer 22 includes, for example, an insulator such as SiO₂, SiN, or SiC. The thickness of the cavity layer 22 is not limited to a particular value. The cavity layer 22 has a thickness of, for example, 600 nm to 2000 nm. This tends to allow the infrared sensor 1a to absorb infrared radiation with a wavelength ranging from 8 µm to 14 µm.

The base material of the semiconductor included in each of the p-type part 11 and the n-type part 12 may be a semiconductor material for which the carriers responsible for electrical conduction can be adjusted through doping to either electron holes or electrons. Examples of such a semiconductor material include Si, SiGe, SiC, GaAs, InAs, InSb, InP, GaN, ZnO, and BiTe. The base material of the semiconductor is not limited to those exemplified above. The base material of the semiconductor may be a monocrystalline material, a polycrystalline material, or an amorphous material. For a monocrystalline material, the atomic arrangement is maintained in order for extended distances. The kind of the base material of the semiconductor included in the n-type part 12 may be either the same as or different from the kind of the base material of the semiconductor included in the p-type part 11.

The material of the support layer 15s is not limited to a particular material. The material of the support layer 15s is, for example, different from the material of the thermocouple layer 15t. The material of the support layer 15s may be a semiconductor material such as Si, SiGe, SiC, GaAs, InAs, InSb, InP, GaN, or ZnO, or may be an insulator material such as SiO₂, SiN, or Al₂O₃. The material of the support layer 15s may be a monocrystalline material, a polycrystalline material, or an amorphous material.

The material of the protective layer 15p may be either the same as or different from the material of the thermocouple layer 15t. The material of the protective layer 15p is not limited to a particular material. The material of the protective layer 15p may be a semiconductor material such as Si, SiGe, SiC, GaAs, InAs, InSb, InP, GaN, or ZnO, or may be an insulator material such as SiO₂, SiN, or Al₂O₃. The material of the protective layer 15p may be a monocrystalline material, a polycrystalline material, or an amorphous material.

The hot junction 13 is made of, for example, a metal film or a metal compound film. The metal film or metal compound film that constitutes the hot junction 13 is not limited to a particular film, but may be, for example, a film of a metal or metal compound used in semiconductor processes, such as TiN, TaN, Al, Ti, or Cu. The sheet resistance of the metal film or metal compound film constituting the hot junction 13 may be matched to the impedance of the vacuum to allow the hot junction 13 to serve as an infrared absorption layer. For example, if the hot junction 13 includes TiN, adjusting the thickness of the hot junction 13 to about 10 nm makes it possible to match the sheet resistance of the hot junction 13 to the impedance of the vacuum.

The material of the wiring layer 37 is not limited to a particular material. The wiring layer 37 is made of, for example, an extrinsic semiconductor, a metal, or a metal compound. Examples of the metal and the metal compound may include materials used in common semiconductor processes, such as Al, Cu, TiN, and TaN.

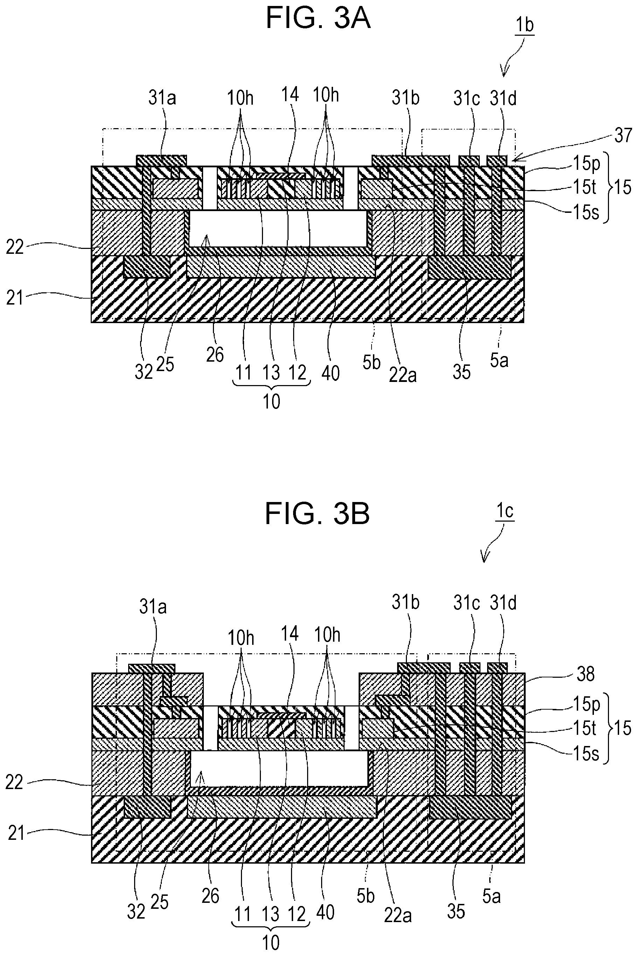

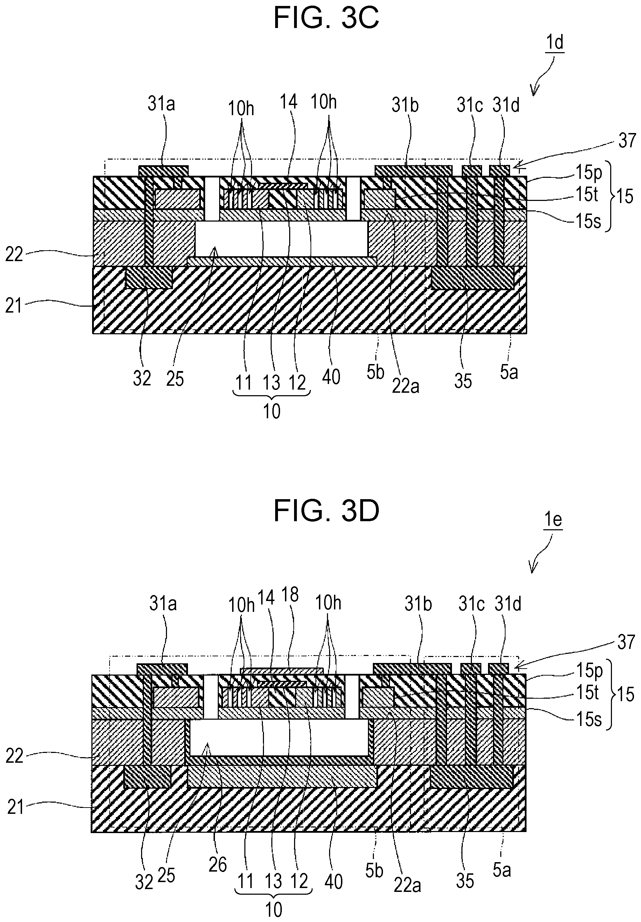

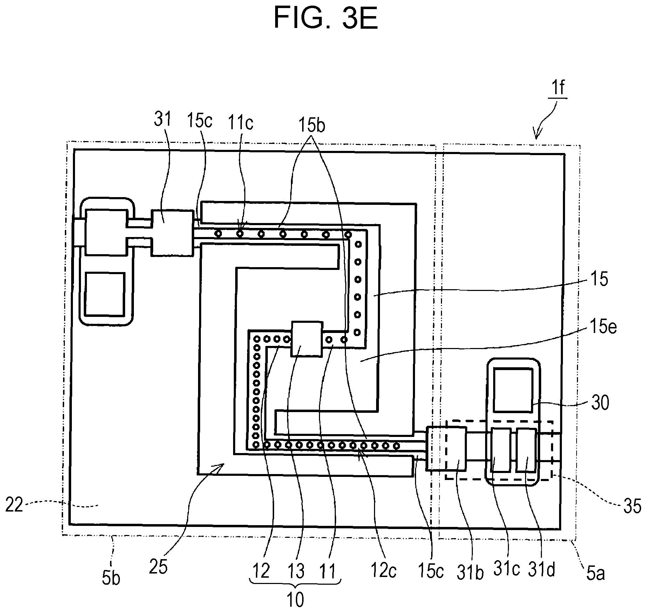

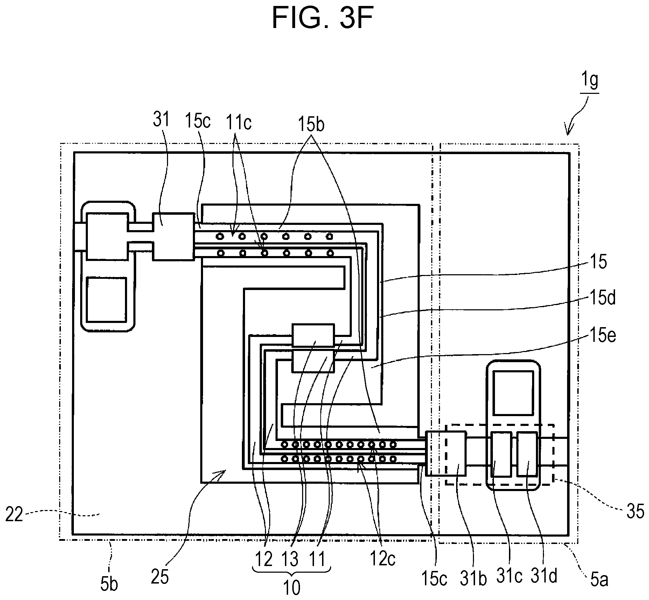

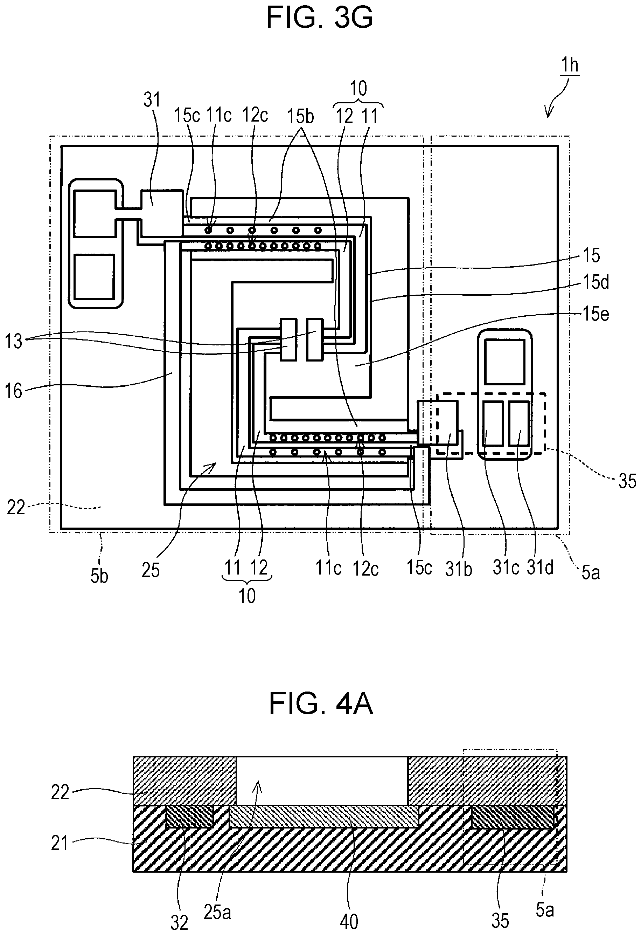

The infrared sensor 1a can be changed from various viewpoints. Figs. 3A, 3B, 3C, 3D, 3E, 3F, and 3G illustrate modifications of the infrared sensor 1a. These modifications are similar in configuration to the infrared sensor 1a, except for features specifically described otherwise. Components according to individual modifications identical or corresponding to the components of the infrared sensor 1a are designated by the same reference signs, and not described in further detail. Descriptions related to the infrared sensor 1a also apply to these modifications insofar as no technical contradiction arises.

As illustrated in Fig. 3A, an infrared sensor 1b includes, for example, a protective film 26. The protective film 26 is, for example, provided along the bottom face of the cavity 25. The protective film 26 is, for example, disposed on the infrared reflector 40. The configuration mentioned above allows the infrared reflector 40 to be protected from oxidizing environments and chemical solutions.

The material of the protective film 26 is not limited to a particular material. The material of the protective film 26 is, for example, different from the material of the infrared reflector 40. The protective film 26 includes, for example, an insulator such as SiO₂, SiN, or SiC. The thickness of the protective film 26 is not limited to a particular value. The thickness of the protective film 26 is, for example, 10 nm to 200 nm.

As illustrated in Fig. 3B, an infrared sensor 1c includes, for example, the protective film 26. In addition, the infrared sensor 1c includes an insulating film 38. The insulating film 38 is disposed on top of the sensor layer 15. For example, at least part of each of the wiring lines 31a, 31b, 31c, and 31d extends within a contact hole defined in the insulating film 38. The configuration mentioned above allows the insulating film 38 to protect the sensor layer 15.

As illustrated in Fig. 3C, in an infrared sensor 1d, the infrared reflector 40 may be disposed on one major surface of the substrate 21. For example, a film of a semiconductor such as polysilicon is formed on one major surface of the substrate 21, and doping is applied to the film to thereby obtain the infrared reflector 40.

As illustrated in Fig. 3D, an infrared sensor 1e includes, for example, the protective film 26. In addition, the infrared sensor 1e further includes an infrared absorption layer 18. The infrared absorption layer 18 is, for example, disposed on the sensor layer 15. In plan view, the infrared absorption layer 18 overlaps the hot junction 13. The infrared sensor 1e thus tends to have increased sensitivity to infrared radiation. The infrared absorption layer 18 is not limited to a particular configuration. The infrared absorption layer 18 may be a film of a material such as TaN, Cr, or Ti, may be a porous metal film, or may be a dielectric such as SiO₂.

As illustrated in Fig. 3E, in an infrared sensor 1f, each of the first phononic crystal 11c and the second phononic crystal 12c is provided not only in the beam 15b but also in the infrared receiver 15e. This allows for further increased thermal insulation between the substrate 21 and the infrared receiver 15e.

As illustrated in Figs. 3F and 3G, infrared sensors 1g and 1h each include multiple thermocouples 10.

In the infrared sensor 1g, the thermocouples 10 are disposed in parallel. In this case, even if one of the thermocouples 10 breaks down, another thermocouple 10 can be used to detect infrared radiation.

In the infrared sensor 1h, the thermocouples 10 are disposed in series.
In this case, an output corresponding to the sum of thermoelectromotive forces generated in the thermocouples 10 is obtained. The infrared sensor 1h thus tends to have increased sensitivity. As illustrated in Fig. 3G, the infrared sensor 1h includes a cold junction 16. The cold junction 16 is connected to the joint 15c. The cold junction 16 electrically connects the thermocouples 10 to each other. The cold junction 16 includes, for example, a metal film. As illustrated in Fig. 3G, in the infrared sensor 1h, the p-type part 11 and the n-type part 12 are provided in the same beam 15b. Consequently, the first phononic crystal 11c and the second phononic crystal 12c are provided in the same beam 15b.

An example of a method for manufacturing the infrared sensor 1a according to Embodiment 1 is described below. The method for manufacturing the infrared sensor 1a is not limited to the method described below.

The method for manufacturing the infrared sensor 1a includes, for example, Items (I) and (II) described below. (I) Forming the flat major surface 22a by flattening an irregular surface of a multilayer body 50 including the transistor 35. The flat major surface 22a includes a surface of a sacrificial region 51a that is positioned away from the transistor 35 in plan view. In addition, the flat major surface 22a overlaps the transistor 35 in plan view.
(II) Forming the sensor layer 15 on the flat major surface 22a. The sensor layer 15 includes the phononic crystals 11c and 12c in which the holes 10h are arranged.

With the manufacturing method mentioned above, lithography for forming the phononic crystals 11c and 12c can be performed on the major surface 22a, which is a flat surface with no steps. This tends to lead to reduced defects in the phononic crystals 11c and 12c, and to increased infrared detection accuracy of the infrared sensor 1a.

In manufacturing the infrared sensor 1a, for example, the cavity 25 is formed by etching away the sacrificial region 51a.

As illustrated in Fig. 4A, a pixel selection switch including the transistor 35 is created in one region of the substrate 21. The first region 5a is thus defined. The substrate 21 is, for example, a Si substrate. The transistor 35 can be, for example, manufactured in accordance with a known transistor manufacturing method. Additionally, the ground 32 is created in another region of the substrate 21. After the transistor 35 is created, an impurity such as boron or phosphorus is implanted at high concentration into a region of the substrate 21 that is to become the infrared reflector 40. Then, annealing is performed at a temperature from 1000°C to 1100°C, which causes carriers to be activated in a region on the substrate 21 that has been doped with the impurity at high concentration. The doped region thus serves as the infrared reflector 40. Subsequently, an interlayer film including a dielectric such as SiO₂ is formed on the surface of the substrate 21. The interlayer film can be formed by use of deposition methods such as chemical vapor deposition (CVD) and sputtering. A recess 25a is formed in the interlayer film by photolithography and etching. The cavity layer 22 is thus obtained.

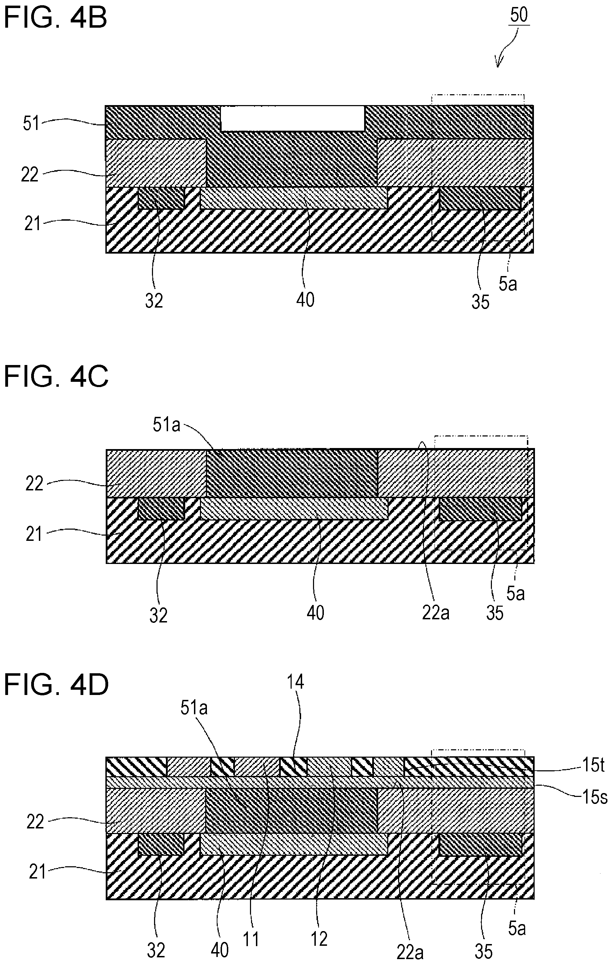

Subsequently, as illustrated in Fig. 4B, a sacrificial layer 51 is formed so as to cover the recess 25a. The sacrificial layer 51 is made of, for example, a material such as Si that is different from the material of the cavity layer 22.

As illustrated in Fig. 4C, the sacrificial layer 51 is removed in regions outside of the recess 25a by chemical mechanical polishing (CMP) or other methods. As a result, the sacrificial region 51a is formed in the cavity layer 22, and the flat major surface 22a is formed. More specifically, for example, for a region with irregularities of about 500 to 1000 nm, flattening is performed by chemical mechanical polishing such that the mean height from the surface of the substrate to the major surface of the cavity layer in the first region, and the mean height from the surface of the substrate to the major surface of the cavity layer in the second region have a difference of less than or equal to 50 nm.

Subsequently, as illustrated in Fig. 4D, the support layer 15s is formed on the flat major surface 22a. The support layer 15s includes a material different from the material of the sacrificial region 51a. For example, the support layer 15s is a film of a material such as SiOi or SiN. Subsequently, the thermocouple layer 15t made of a semiconductor such as Si is formed. The p-type part 11 and the n-type part 12 are then formed through doping. The doping may be performed by use of a known method such as ion implantation. After doping with an impurity, annealing is performed, which causes carriers to be activated.

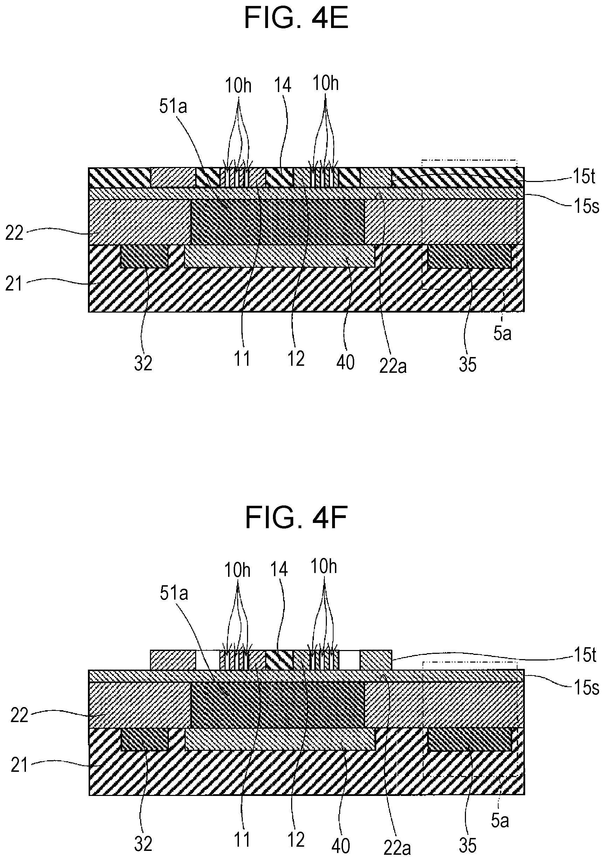

Subsequently, as illustrated in Fig. 4E, the first phononic crystal 11c and the second phononic crystal 12c are formed in the thermocouple layer 15t. To form the first phononic crystal 11c and the second phononic crystal 12c, a predetermined kind of lithography is used in accordance with the shape and size of the holes 10h. For example, to form the holes 10h with a period greater than or equal to 300 nm, photolithography is used. To form the holes 10h with a period from 100 nm to 300 nm, electron beam lithography is used. To form the holes 10h with a period from 1 nm to 100 nm, block copolymer lithography is used. To form the first phononic crystal 11c and the second phononic crystal 12c, nanoimprint lithography or other kinds of lithography may be used. Any of the above kinds of lithography allows for formation of the phononic crystals in any region of the thermocouple layer 15t.

A phononic crystal including multiple kinds of unit cells 10k as illustrated in Figs. 2E, 2N, and 2O can be formed through preparation, in advance, of writing patterns corresponding to the multiple kinds of unit cells by means of photolithography or electron beam lithography. Such a phononic crystal including multiple kinds of unit cells may be formed by a combination of multiple kinds of lithography. For example, unit cells with a comparatively small period are formed in a desired region by block copolymer lithography or electron beam lithography. Then, unit cells with a comparatively large period are formed in the same region in an overlapping manner by photolithography.

As illustrated in Fig. 4F, after the first phononic crystal 11c and the second phononic crystal 12c are formed, photolithography and etching are performed to define a region constituting the thermocouple layer 15t.

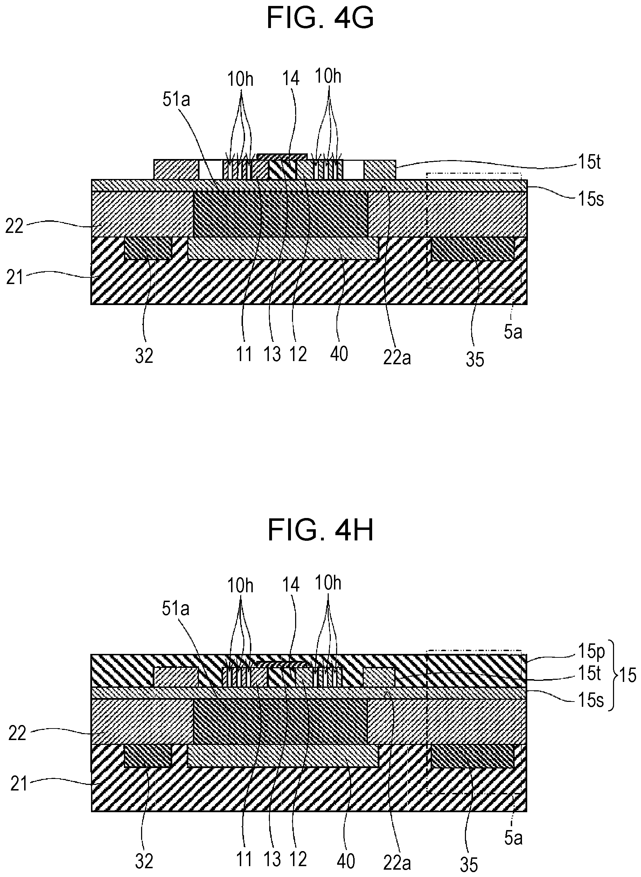

Subsequently, as illustrated in Fig. 4G, a film of a metal compound such as TiN or TaN, or a film of a metal such as Al, Cr, Ti, or Cu is formed on the thermocouple layer 15t, and the metal compound film or the metal film is etched to thereby form the hot junction 13.

As illustrated in Fig. 4H, after the hot junction 13 is formed, a film of a material such as SiOi or SiN is formed so as to cover the thermocouple layer 15t to thereby form the protective layer 15p. In this way, the sensor layer 15 is obtained. After the protective layer 15p is formed, the surface of the protective layer 15p is flattened by CMP. This allows the subsequent fabrication of wiring to be performed with accuracy.

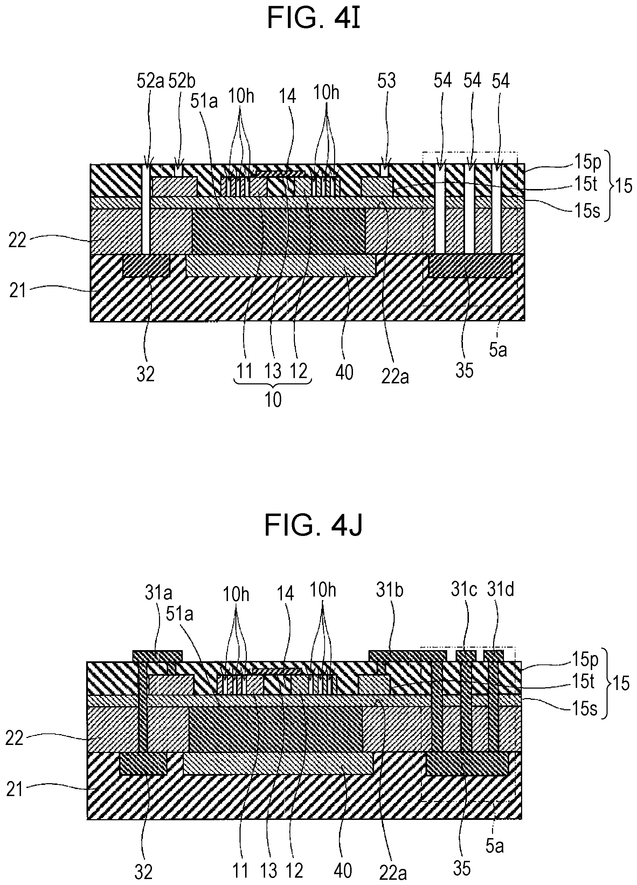

Subsequently, as illustrated in Fig. 4I, contact holes 52a, 52b, 53, and 54 are formed in the sensor layer 15 and the cavity layer 22 by photolithography and etching. The contact hole 52a extends from the surface of the sensor layer 15 to the ground 32. The contact hole 52b extends from the surface of the sensor layer 15 to the p-type part 11. The contact hole 53 extends from the surface of the sensor layer 15 to the n-type part 12. The contact holes 54 extends from the surface of the sensor layer 15 to the transistor 35.

Subsequently, as illustrated in Fig. 4J, a metal film made of a metal such as Al is formed so as to cover the sensor layer 15. As the metal film is formed, the interior of each of the contact holes 52a, 52b, 53, and 54 is filled with the metal. The metal film on the surface of the sensor layer 15 is partially removed by photolithography and etching to thereby form the wiring lines 31a, 31b, 31c, and 31d. These wiring lines are electrically connected to a signal processing circuit formed separately in the substrate 21 or outside of the substrate 21.

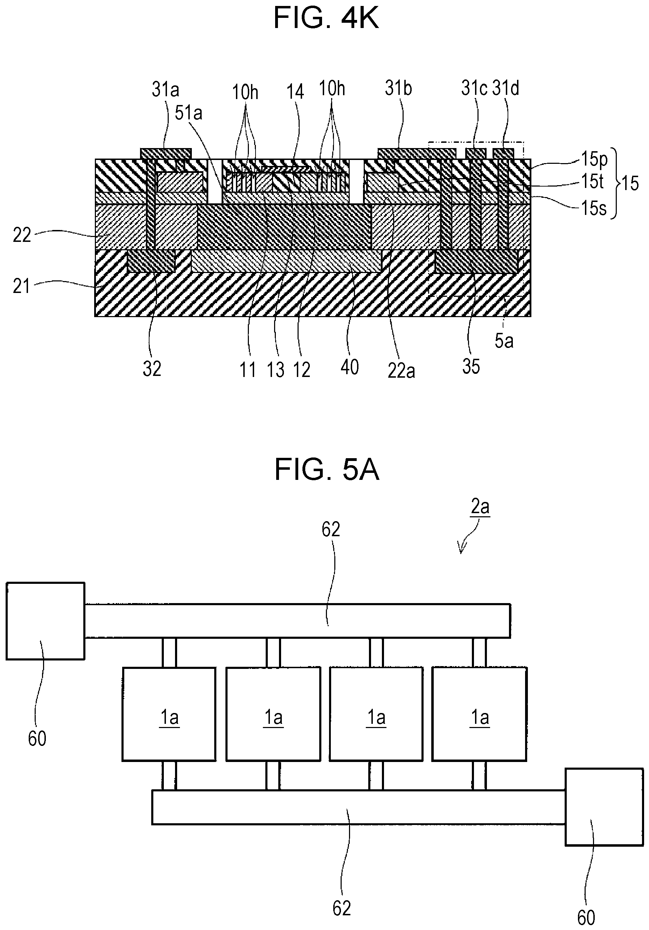

Subsequently, as illustrated in Fig. 4K, the support layer 15s and the protective layer 15p are partially etched to thereby define the infrared receiver 15e and the beam 15b. In this case, the support layer 15s and the protective layer 15p are etched such that the sacrificial region 51a is partially exposed. Lastly, the sacrificial region 51a is removed by selective etching. As a result, the cavity 25 is formed in the cavity layer 22, and the beam 15b and an infrared receiver 15d in the sensor layer 15 are suspended while being spaced apart from the cavity layer 22. In this way, the infrared sensor 1a is manufactured.

The infrared sensors 1b to 1h can be manufactured by employing the manufacturing method mentioned above. For example, if the protective film 26 is to be formed as with the infrared sensor 1b, the protective film 26 may be formed after the recess 25a is formed, such that the protective film 26 covers the bottom face of the recess 25a. In this case, portions of the protective film 26 that cover areas other than the bottom and lateral faces of the recess 25a are removed by photolithography and etching.

The manufacturing method mentioned above can be employed to manufacture the infrared sensor 1a also for a case where, in the infrared sensor 1a, the interface scattering frequency of phonons in the first phononic crystal 11c differs from the interface scattering frequency of phonons in the second phononic crystal 12c.

Reference is now made to an exemplary method for creating the sensor layer 15 such that the interface scattering frequency of phonons in the first phononic crystal 11c differs from the interface scattering frequency of phonons in the second phononic crystal 12c.

For example, in accordance with the first phononic crystal 11c and the second phononic crystal 11c, a photomask designed with holes having different diameters, different periods, or different unit cells is prepared. A pattern for the first phononic crystal 11c may be formed on the same photomask as the photomask used for forming the second phononic crystal 12c, or may be formed on a photomask different from the photomask used for forming the second phononic crystal 12c. Through exposure and development processes, the pattern for each of the first phononic crystal 11c and the second phononic crystal 12c written on the photomask is transferred to a resist film applied onto the thermocouple layer 15t. Subsequently, the thermocouple layer 15t is etched from the top face of the resist film to thereby form the holes 10h for each of the first phononic crystal 11c and the second phononic crystal 12c. Lastly, the resist film is removed. The holes 10h in each of the first phononic crystal 11c and the second phononic crystal 12c are thus obtained.

Reference is now made to a case where phononic crystals are formed by electron beam lithography. For a region corresponding to the first phononic crystal 11c and a region corresponding to the second phononic crystal 12c, writing patterns of holes with different diameters, different periods, or different unit cells are input to an electron beam irradiation apparatus. In accordance with the input data, an electron beam is scanned to irradiate the thermocouple layer 15t. Respective patterns for the first phononic crystal 11c and the second phononic crystal 12c are thus directly written on a resist film applied onto the thermocouple layer 15t. After the written pattern is developed, the thermocouple layer 15t is etched from the top face of the resist film onto which the pattern has been transferred. The holes 10h for each of the first phononic crystal 11c and the second phononic crystal 12c are thus formed. Lastly, the resist film is removed to thereby obtain the holes 10h in each of the first phononic crystal 11c and the second phononic crystal 12c.

If the phononic crystals are to be formed by block copolymer lithography, for example, block copolymers with different compositions are used for forming the first phononic crystal 11c and for forming the second phononic crystal 12c. The period and arrangement pattern of self-assembly structures in a block copolymer vary with the kind of the block copolymer or with the compositional ratio between individual polymers in the block copolymer. Accordingly, using two kinds of block copolymers with different compositions makes it possible to form two kinds of phononic crystals with different diameters, different periods, or different unit cells. First, the first phononic crystal 11c is formed through block copolymer lithography by use of a first block copolymer. The second phononic crystal 12c is then formed through block copolymer lithography by use of a second block copolymer. It is to be noted that known process conditions may be used for the block copolymer lithography.

### (Embodiment 2)

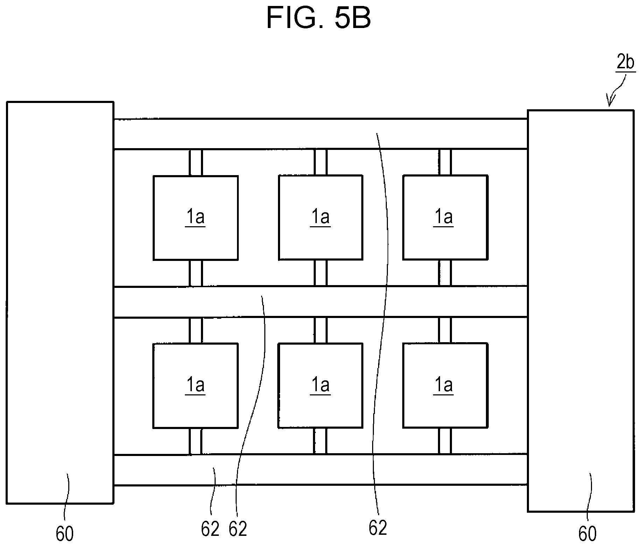

Figs. 5A and 5B respectively illustrate sensors arrays 2a and 2b according to Embodiment 2. The sensor arrays 2a and 2b each include infrared sensors 1a arranged in one dimension or in two dimensions. The infrared sensors 1a arranged in one dimension or in two dimensions are interconnected by signal processing circuits 60 and wiring lines 62. In each of the sensor arrays 2a and 2b, the infrared sensors arranged in one dimension or in two dimensions may include, instead of the infrared sensor 1a, one infrared sensor selected from the group consisting of the infrared sensors 1a to 1h. In each of the sensor arrays 2a and 2b, the infrared sensors arranged in one dimension or in two dimensions may include multiple kinds of infrared sensors selected from the group consisting of the infrared sensors 1a to 1h.

The first region of the infrared sensor according to the present disclosure may include, in addition to or instead of the transistor, an element such as a diode or a capacitor, a wiring line, or other components or features.

### Industrial Applicability

The infrared sensor according to the present disclosure can be used for various applications.

### Reference Signs List

1a, 1b, 1c, 1d, 1e, 1f, 1g, 1h infrared sensor
2a, 2b sensor array
10 thermocouple
10h hole
11 p-type part
11c first phononic crystal
12 n-type part
12c second phononic crystal
15 sensor layer
15p protective layer
15s support layer
22 cavity layer
22a flat major surface
25 cavity
35 transistor
40 infrared reflector
51a sacrificial region

## Claims

1. An infrared sensor comprising:
a transistor;
a cavity layer including a cavity; and
a sensor layer including a phononic crystal in which holes are arranged,
wherein in plan view, the infrared sensor includes a first region and a second region, the first region including the transistor, the second region including the cavity,
wherein the cavity layer includes a flat major surface, the flat major surface being disposed around the cavity and extending across both the first region and the second region, and
wherein the sensor layer is disposed on the flat major surface.

2. The infrared sensor according to claim 1, further comprising an infrared reflector that reflects infrared radiation toward the sensor layer.

3. The infrared sensor according to claim 2, wherein the infrared reflector includes doped silicon having a carrier density greater than or equal to 1.0 × 10¹⁹ cm⁻³.

4. The infrared sensor according to any one of claims 1 to 3, wherein the sensor layer includes a support layer, a thermocouple, and a protective layer, the thermocouple being disposed on the support layer, the protective layer covering the phononic crystal.

5. The infrared sensor according to claim 4, wherein the thermocouple includes the phononic crystal.

6. The infrared sensor according to claim 4 or 5,
wherein the thermocouple includes a p-type part and an n-type part, the p-type part having a positive Seebeck coefficient, the n-type part having a negative Seebeck coefficient,
wherein the p-type part includes a first phononic crystal in which first holes are arranged in plan view,
wherein the n-type part includes a second phononic crystal in which second holes are arranged in plan view, and
wherein an interface scattering frequency of phonons in the first phononic crystal differs from an interface scattering frequency of phonons in the second phononic crystal.

7. The infrared sensor according to claim 6, wherein at least one condition selected from the group consisting of (i), (ii), and (iii) below is satisfied.
(i) A distance between two mutually closest holes of the first holes in plan view of the first phononic crystal differs from a distance between two mutually closest holes of the second holes in plan view of the second phononic crystal.
(ii) A ratio of a sum of areas of the first holes to an area of the first phononic crystal in plan view of the first phononic crystal differs from a ratio of a sum of areas of the second holes to an area of the second phononic crystal in plan view of the second phononic crystal.
(iii) A specific surface area of the first phononic crystal differs from a specific surface area of the second phononic crystal.

8. The infrared sensor according to any one of claims 1 to 7,
wherein in the cavity layer, a mean height from a surface of a substrate to the major surface of the cavity layer in the first region, and a mean height from the surface of the substrate to the major surface of the cavity layer in the second region have a difference of less than or equal to 50 nm.

9. A sensor array comprising infrared sensors, the infrared sensors being arranged in one dimension or in two dimensions,
wherein the infrared sensors include the infrared sensor according to any one of claims 1 to 8.

10. A method for manufacturing an infrared sensor, the method comprising:
forming a flat major surface by flattening an irregular surface of a multilayer body including a transistor, the flat major surface including a surface of a sacrificial region positioned away from the transistor in plan view, the flat major surface overlapping the transistor in plan view; and
forming a sensor layer on the flat major surface, the sensor layer including a phononic crystal in which holes are arranged.

11. The method according to claim 10 for manufacturing an infrared sensor, the method further comprising forming a cavity by etching away the sacrificial region.
